# FASCICULE DE BREVET EUROPEEN

(11) **EP 2 019 152 B1**
(45) Date de publication et mention de la délivrance du brevet: **21.03.2012**
(21) Numéro de dépôt: 08160217.9
(22) Date de dépôt: 11.07.2008
(51) Int. Cl.: C23C 16/30, C23C 16/56, C23C 16/40, C23C 16/32, C23C 16/36

(54) **Procédé de préparation de couches minces de matériaux diélectriques nanoporeux**
Herstellungsverfahren von Dünnschichten aus nanoporösen dielektrischen Materialien
Method of preparing thin layers of nanoporous dielectric materials

(30) Priorité: 20.07.2007 FR 0756651
(43) Date de publication de la demande: 28.01.2009
(73) Titulaire: Commissariat à l'Énergie Atomique et aux Énergies Alternatives, 75015 Paris (FR)
(72) Inventeur: Jousseaume, Vincent, 38700, Le Sappey-en-Chartreuse (FR)
(74) Mandataire: Augarde, Eric

(56) Documents cités:
- WO-A-03/044843
- WO-A-2006/079979
- US-A1- 2003 124 870

## Description

### DOMAINE TECHNIQUE

L'invention concerne un procédé de préparation de couches minces de matériaux diélectriques nanoporeux mettant en oeuvre notamment une technique de dépôt chimique en phase vapeur (CVD) et plus particulièrement une technique de dépôt chimique en phase vapeur assisté par plasma (PACVD ou PECVD).

Le domaine technique de l'invention peut être défini de manière générale comme celui de la préparation de couches minces de matériaux diélectriques nanoporeux et en particulier de couches minces nanoporeuses de matériaux à très faible constante diélectrique (« Ultra Low K » ou « ULK » en langue anglaise).

La réalisation de diélectriques nanoporeux en couches minces constitue en effet un domaine de recherche très actif, notamment pour des applications en microélectronique par exemple comme diélectrique à faible permittivité ou comme membrane isolante.

La possibilité de fabriquer ces diélectriques poreux par une technique de dépôt chimique en phase vapeur (« CVD ») et notamment de dépôt chimique en phase vapeur assisté par plasma (« PECVD ») à partir d'équipements déjà disponibles permet une plus grande facilité d'intégration dans les chaînes de production.

Une des applications possibles pour ces diélectriques poreux est la réalisation de matériaux « Ultra low k » (ULK).

La diminution des dimensions critiques des circuits intégrés a peu à peu imposé l'utilisation de ces matériaux comme diélectrique d'isolation dans les interconnexions métalliques. Il s'agit généralement de matériaux composés de Si, O, C et H, nanoporeux, et possédant une constante diélectrique inférieure à 2,7 et idéalement inférieure 2,3.

L'approche couramment utilisée pour réaliser ce type de matériau par une voie CVD nécessite le dépôt d'un matériau comprenant deux phases, à savoir une phase contenant du Si, O, C, H qui constitue le squelette du matériau et une phase organique dite porogène (C, H, O) qui va servir de phase sacrificielle [1]. La phase sacrificielle est dégradée lors d'un traitement adapté qui conduit à la formation d'une couche mince nanoporeuse pour peu que la porosité engendrée par la décomposition du porogène soit supérieure à l'affaissement du squelette observé lors du traitement.

Plus précisément, le document [1] décrit un procédé de dépôt par PACVD ou PECVD de films à faible constante diélectrique, qui comprennent Si, O et C, par réaction d'un ou plusieurs composés organosiliciés sans oxygène, linéaires ; d'un ou plusieurs composés hydrocarbonés sans oxygène ayant un cycle et une ou deux doubles liaisons carbone-carbone dans le cycle ; et d'un ou plusieurs gaz oxydants pour former le squelette du film.

Suite au dépôt, le film subit un traitement de recuit thermique ou assisté par plasma, ou bien un traitement par un faisceau d'électron, qui élimine au moins certains des groupes organiques du film tels que les groupes cycliques pour créer ainsi des vides ou pores dans le film.

Les composés organosiliciés sans oxygène sont notamment des silanes tels que le triméthylsilane et un composé hydrocarboné sans oxygène est par exemple le alpha terpinène.

Il est possible à titre optionnel d'introduire également des composés organosiliciés contenant de l'oxygène dans l'enceinte de dépôt.

Le document [2] décrit la réalisation d'un matériau diélectrique nanoporeux en couche mince déposé par PECVD qui présente une porosité inhomogène en profondeur dans la couche.

De manière plus précise, le document [2] décrit la préparation d'une couche de faible constante diélectrique formée sur un substrat, ladite couche comportant :
- une zone de base, adjacente au substrat dans laquelle sont répartis des pores, la majorité des pores ayant des diamètres dans la plage de 1 à 10 nm ;
- une zone de surface atomiquement lisse ;
- une zone intermédiaire dans laquelle le diamètre des pores est inférieur à 2 nm.

Une telle couche est déposée par réaction de tétraméthylsilane et d'oxygène dans un gaz neutre à une température du substrat de 30°C.

Le film déposé est ensuite traité par un plasma d'hydrogène à 400°C qui crée une croûte à valeur de k plus élevée qui est ensuite éventuellement éliminée par gravure (« Etch back »).

Le procédé de dépôt du document [2] ne nécessite pas la réalisation d'un matériau biphasique mais l'existence d'un gradient de porosité (avec également un gradient de composition) dans la couche poreuse réalisée entraîne une variation des propriétés électriques du film dans le sens de l'épaisseur ce qui peut poser problème si l'on souhaite utiliser ce matériau dans un circuit intégré. De plus, si l'on veut réaliser des interconnexions métalliques en utilisant une approche damascène, il faut graver des tranchées ou des trous de contacts dans le diélectrique poreux. La présence de cette inhomogénéité de porosité complique grandement le contrôle du procédé de gravure qui lui est appliqué et qui doit être adapté en fonction de la profondeur gravée.

Le Document WO-A-03/044843 [6] décrit la préparation de couches diélectriques « low K ». Dans ce procédé, on réalise les étapes suivantes :
- on dépose une couche diélectrique sur un substrat, cette couche diélectrique comprenant du Si, du C et de l'oxygène ;
- on expose la surface de la couche diélectrique à un plasma d'oxygène, d'azote ou d'hydrogène pour former une peau semi-perméable sur ou de la surface de la couche ;
- on recuit la couche de façon à rendre poreuse au moins une partie de la couche ; ou bien
- on dépose une couche diélectrique sur un substrat, cette couche diélectrique comprenant du Si, du C et de l'oxygène ;
- on recuit au moins partiellement une zone de surface de la couche ; et
- on recuit la couche pour rendre la masse de la couche poreuse ; ou bien
- on dépose une couche diélectrique sur un substrat, cette couche diélectrique comprenant du Si, du C et de l'oxygène ;
- on forme ou on dépose une couche semi-perméable sur
ou de la surface de la couche ; et
- on durcit la couche, moyennant quoi au moins une partie de la couche est rendue poreuse.

Dans ce document on utilise donc le gaz créé essentiellement par le dégagement d'OH, d'eau, à l'intérieur du film pour créer une structure poreuse à l'intérieur de celui-ci.

En traitant la surface exposée du film de manière à former une peau semi-perméable sur la surface du film et/ou en recuisant partiellement la couche de surface, le dégagement de gaz est réduit et/ou contrôlé de sorte que lorsque la couche est recuite, le matériau se fige avec création d'une structure plus ou moins poreuse due au dégagement de gaz.

Dans les exemples ([0145]), une couche épaisse de 5000 A de dioxyde de silicium contenant des méthyles a été déposée à partir de tétraméthyl silane et d'oxygène dans de l'azote en tant que gaz vecteur.

Le Document US-A1-2003/124870 [7] décrit un procédé analogue à celui du document [6].

Le Document WO-A-2006/079979 [8] décrit un procédé de fabrication d'un dispositif semi-conducteur comprenant les étapes consistant à appliquer une couche de matériau diélectrique non recuit ou seulement partiellement recuit sur un substrat, cette couche comportant une surface exposée; et à recuire le matériau diélectrique.

L'étape de recuit du matériau diélectrique consiste en un premier recuit partiel pour former une couche dense près de la surface exposée ou au niveau de celle-ci, cette couche dense jouant le rôle de couche de protection pendant au moins une étape ultérieure de fabrication du matériau diélectrique, et en un recuit ultérieur pour durcir le matériau.

Le matériau peut comprendre un matériau de type SiCO:H qui peut être appliqué par une technique CVD.

A la page 6, lignes 31 à 34, il est fait référence au document [6] pour indiquer que de manière analogue à celui-ci des pores peuvent être créés dans la couche à faible k.

Comme cela ressort clairement des figures 1A et 1 B du document [6] le mécanisme physique mis en oeuvre dans le procédé de ce document mais aussi dans les procédés des documents [7] et [8] implique la condensation de silanol pour former de l'eau puis le moussage avec de l'eau.

De ce fait, il n'est pas possible avec le procédé des documents [6], [7] et [8] mais aussi avec celui des documents [1] et [2] d'obtenir une porosité dans des matériaux ne comportant pas d'oxygène tels que par exemple SiCH, SiCN, SiCNH, ou encore SiCF.

Il existe donc, au vu de ce qui précède, un besoin pour un procédé de préparation d'une couche mince d'un matériau nanoporeux en particulier par la technique de dépôt chimique en phase vapeur (« CVD ») et en particulier la technique de dépôt chimique en phase vapeur assisté par plasma (« PECVD » ou « PACVD »), qui soit simple, fiable, facile à mettre en oeuvre, et qui permette le dépôt de couches minces présentant une porosité homogène, c'est-à-dire une porosité uniformément répartie dans l'ensemble de la couche et sur la totalité de son épaisseur, la taille des pores étant par ailleurs sensiblement la même dans l'ensemble de la couche.

Il existe en outre un besoin pour un procédé qui nécessite un nombre limité de précurseurs pour préparer la couche, de préférence un seul, et qui puisse être mis en oeuvre dans des équipements existants, par exemple des équipements de CVD existants.

Il existe plus précisément un besoin pour un procédé qui permette d'obtenir une porosité dans des matériaux ne comprenant pas d'oxygène tels que SiCH, SiCN, SiCNH ou SiCF dans lesquels une porosité n'a jamais pu être obtenue jusqu'à présent.

Le but de la présente invention est de fournir un procédé de préparation d'une couche mince d'un matériau nanoporeux qui réponde entre autres aux besoins énumérés ci-dessus.

Le but de la présente invention est encore de fournir un tel procédé qui ne présente pas les inconvénients, défauts, limitations et désavantages des procédés de l'art antérieur tel que représenté notamment par les documents [1], [2], [6], [7] et [8] cités ci-dessus, qui résolve les problèmes de l'art antérieur, et qui permette notamment de préparer une couche mince d'un matériau nanoporeux à porosité homogène, dans des matériaux ne comprenant pas d'oxygène.

Ce but, et d'autres encore, sont atteints, conformément à l'invention, par un procédé de préparation d'une couche mince d'un matériau diélectrique nanoporeux à porosité homogène dans lequel on réalise les étapes indiquées dans la revendication 1.

Le matériau de la première couche mince est sans oxygène, ne comprend pas d'oxygène, est exempt d'oxygène.

Le procédé selon l'invention comprend une suite spécifique d'étapes spécifiques qui ne sont ni décrites ni suggérées dans l'art antérieur.

Précisons que dans la présente invention on entend généralement par couche mince aussi bien dans le cas de la première couche mince que de la deuxième couche mince, une couche d'une épaisseur de 5 à 1500 nm, de préférence de 10 à 1000 nm, de préférence encore de 80 à 600 nm.

Par nanoporosité, nanopores, on entend généralement que les pores ont une dimension, généralement définie par leur diamètre moyen, inférieure à 10 nm, de préférence de 0,5 à 4 nm.

Par porosité homogène, on entend généralement que cette porosité est répartie uniformément dans l'ensemble de la couche nanoporeuse et en particulier sur l'épaisseur de celle-ci, et que, en outre, le diamètre moyen des pores est substantiellement le même dans toute la couche mince.

Il est généralement important de définir le terme moussage qui est la génération d'un gaz dans un matériau sous l'action d'un traitement thermique, UV, plasma, etc... entraînant la création de nanovides, traditionnellement appelés « nanocellules » dans le matériau.

Le procédé selon l'invention peut être défini comme procédé d'obtention d'une couche mince de matériau poreux à porosité homogène, sur un substrat, ce procédé comprenant :
- le dépôt d'une couche de préférence diélectrique contenant ou non des inclusions organiques sur un substrat ;
- le dépôt d'une couche par-dessus la précédente, cette couche faisant office de « croûte » contrôlée en épaisseur et en composition ;
- le traitement de l'empilement constitué de la couche diélectrique et de la croûte, de façon à créer de la porosité dans la première couche diélectrique ;
- éventuellement le retrait de la croûte par tout procédé adéquat tel que la gravure chimique ou plasma, ou encore le polissage chimico-mécanique (« CMP » en anglais).

Le procédé selon l'invention est basé sur un principe fondamentalement différent de celui des procédés de l'invention de l'art antérieur dans lesquels la porosité est générée par simple dégradation de la couche initialement déposée, ou plus précisément d'une phase organique sacrificielle de cette couche, élimination de fonctions, groupes organiques se trouvant dans cette couche, et réorganisation, restructuration de cette couche sans moussage.

La manière de procéder de l'art antérieur entraîne une porosité insuffisante et un effondrement, affaissement de la couche.

Dans le procédé selon l'invention, les pores sont créés du fait de la génération d'un gaz dans la première couche déposée, en d'autres termes par moussage, et non par exemple par simple dégradation, élimination d'une phase sacrificielle. Cette génération de gaz, moussage se trouve contenue, limitée, voire empêchée, par la couche dite croûte déposée sur la première couche mince ce qui conduit à une meilleure répartition de la porosité que dans les procédés sans moussage à approche « porogène » simple ainsi qu'à une augmentation significative du taux de porosité dans la couche mince initialement déposée.

En outre, le procédé de l'invention fait aussi appel à un mécanisme totalement différent de celui sur lequel sont basés les procédés des documents [6], [7] et [6], qui implique la condensation de silanol pour former de l'eau, puis le moussage avec de l'eau. Ce qui implique qu'il n'est pas possible avec les procédés de ces documents de préparer des couches nanoporeuses de matériaux sans oxygène.

Le procédé selon l'invention répond donc à l'ensemble des besoins énumérés ci-dessus, surmonte les inconvénients des procédés de l'art antérieur et résout les problèmes posés par ces procédés.

Le procédé selon l'invention permet la préparation pour la première fois de couches minces nanoporeuses à porosité élevée et homogène, sans affaissement dans des matériaux ne comportant pas d'oxygène.

Le procédé selon l'invention est simple, fiable, facile à mettre en oeuvre et peut être réalisé dans des appareillages existant, classiques sans qu'il soit nécessaire de les adapter.

Comme on l'a déjà mentionné plus haut, l'approche adoptée dans le procédé de l'invention s'écarte totalement de l'approche suivie jusqu'à présent pour générer une nanoporosité dans les couches diélectriques, et notamment dans les couches diélectriques ne comportant pas d'oxygène, et va en fait à l'encontre de préjugés largement répandus dans ce domaine de la technique et triomphe de ces préjugés.

En effet, dans le cas du procédé décrit dans le document [2], l'homme du métier de la microélectronique n'a pas complètement compris le phénomène physique mis en jeu dans la création de porosité. Les différents articles tentant de décrire ce mécanisme parlent d'une restructuration du squelette de SiO lors du traitement plasma par l'intermédiaire de la réticulation des silanols [3]. Une des hypothèses surprenantes qui est à la base de la présente invention est plutôt qu'un moussage d'un gaz généré lors du traitement post-dépôt est à l'origine de la création de la porosité dans ce type d'approche. On met donc à profit selon l'invention ce phénomène de moussage et on cherche à le provoquer et à le contrôler selon l'invention notamment grâce à la couche de « croûte ».

Cette hypothèse va à l'encontre de certains a priori de l'homme du métier dans le domaine des mousses selon lesquels il est bien connu que cette technique du moussage n'est pas applicable pour des couches minces nanoporeuses, à savoir pour des diamètres moyens des pores inférieurs à 10 nm [4]. De plus, la formation de ces matériaux nanocellulaires, c'est le terme utilisé en moussage, repose généralement sur un procédé complexe comprenant la saturation du polymère à faire mousser par un gaz inerte dans une enceinte haute pression, par exemple du CO₂ super critique [5]. Enfin, le moussage a été décrit pour les polymères, le plus souvent organiques, mais pas pour les matériaux diélectriques déposés par une technique CVD.

Autrement dit, l'approche suivie selon l'invention permet de compenser l'affaissement observé traditionnellement dans une approche dite « porogène » sans moussage et d'augmenter significativement le taux de porosité dans des couches par rapport aux procédés de l'art antérieur.

Par ailleurs, de manière totalement étonnante, le procédé selon l'invention permet d'obtenir une porosité dans des matériaux, autres que SiOCH, sans oxygène, où une porosité n'avait jusqu'alors jamais été obtenue, comme par exemple SiCH, SiCN, SiCNH, ou SiCF. Pour la première fois grâce au procédé selon l'invention une porosité est obtenue dans ces matériaux.

Si l'on considère les documents [6], [7] et [8] comme on l'a déjà indiqué plus haut, le mécanisme conduisant à la porosité dans les procédés de ces documents est fondamentalement basé sur la condensation de silanol pour former de l'eau puis le moussage avec de l'eau.

Dans les procédés des documents [6], [7] et [8], la présence d'oxygène est donc obligatoire dans le matériau de la couche pour obtenir ensuite une porosité. Il est donc totalement étonnant que selon l'invention on puisse obtenir une porosité avec des matériaux ne comportant pas d'oxygène et par exemple ne comportant que Si, C et éventuellement un ou plusieurs parmi H, N et F.

Il s'agit là d'un second préjugé, à l'encontre duquel va le procédé selon l'invention et qui est surmonté par le procédé selon l'invention.

Le procédé selon l'invention permet de produire une porosité dans des matériaux qui n'avaient jamais été rendus poreux auparavant.

Le procédé selon l'invention va maintenant être décrit de manière plus précise dans la description détaillée qui suit.

Dans la première étape du procédé selon l'invention, on dépose une couche mince d'un premier matériau. Ce matériau consiste en du Si, du C et l'un ou plusieurs parmi H, N et F. Ce matériau est par exemple SiCH, SiCN, SiCNH, ou bien SiCF. Conformément à l'invention, ce matériau ne comprend pas d'oxygène, est exempt d'oxygène.

Dans l'ensemble de la présente description, il est à noter que ces notations (SiCH, etc.) couramment utilisés dans ce domaine de la technique n'indiquent pas la composition atomique de ces composés mais plutôt que ces composés contiennent certains atomes. Ainsi, SiCH est simplement un composé contenant Si, C et H ; SiCF est un composé contenant Si, C et F, mais ces composés ne contiennent pas respectivement 1 atome de Si, de C et de H ou un atome de Si, de C et de F.

Du fait que le but du procédé est de préparer en tant que produit final une couche diélectrique, cette première couche est généralement une couche diélectrique.

Le caractère diélectrique de la première couche mince déposée se trouve renforcé par le procédé de l'invention.

Par matériau diélectrique, on entend généralement un matériau dont la constante diélectrique k est <6. De préférence, ce matériau est un matériau à très faible constante diélectrique « ULK » à savoir dont la constante diélectrique k est inférieure à 3.

Il n'est généralement pas nécessaire que le matériau de la première couche mince initialement déposée présente une telle constante diélectrique très faible à ce stade du procédé.

Une telle constante diélectrique « ULK » pourra être atteinte à l'issue du procédé grâce au renforcement du caractère diélectrique dû au procédé.

Le matériau de la première couche peut être aussi un matériau biphasique avec une phase contenant (de préférence consistant en) Si, C, H et une phase organique porogène contenant (de préférence consistant en) C, H, comme dans le cas d'une approche porogène de l'art antérieur (représenté par exemple par le document [1]) mais le dépôt doit bien sûr être réalisé dans des conditions telles que la première couche mince ait une composition permettant de générer un gaz, de provoquer son moussage, lors de l'étape de moussage ultérieure.

Par « conditions telles que la première couche mince ait une composition permettant de générer un gaz lors d'une étape de moussage ultérieure » ou plus simplement « conditions permettant le moussage », on entend généralement des conditions assurant la présence dans la première couche de groupes organiques susceptible de générer, lors du traitement de moussage ultérieur, des gaz dans la première couche mince déposée.

Ces groupes organiques sont généralement choisis parmi les groupes hydrocarbonés tels que les groupes alkyle ayant de 1 à 10C comme les groupes méthyle, éthyle, propyle, butyle, etc....

Selon la nature des groupes organiques, des gaz différents seront générés dans la première couche mince déposée. Ainsi, le groupe méthyle conduira à la formation de méthane CH₄, et le groupe éthyle conduira à la formation d'éthane C₂H₄.

L'homme du métier saura adapter les conditions du dépôt pour que ces groupes organiques soient présents dans la première couche à une teneur permettant de générer la quantité de gaz adéquate pour produire la porosité voulue lors de l'étape de moussage.

Pour que des groupes organiques soient présents, le dépôt de la première couche doit donc être effectué à basse température à savoir de 20°C à 250°C, généralement en atmosphère non oxydante selon le matériau que l'on souhaite déposer.

Une atmosphère non oxydante conduira par exemple à du SiCH.

Le procédé de dépôt utilisé pour déposer la première couche mince de matériau diélectrique est choisi de manière générale parmi les procédés de dépôt de couches minces à partir d'une solution de précurseurs.

Ce procédé peut ainsi être choisi parmi les procédés de dépôt chimique en phase vapeur CVD, le procédé de dépôt chimique en phase vapeur assisté par plasma PECVD ou PACVD, ou le procédé d'enduction centrifuge (« spin coating »).

Le procédé préféré est le procédé de dépôt CVD, ou le procédé PECVD ou PACVD qui utilise un ou des précurseurs choisis par exemple parmi les composés organosiliciés sans oxygène, les composés hydrocarbonés sans oxygène, l'ammoniac, et leurs mélanges. Le dépôt par PECVD est de préférence réalisé dans des conditions de basse température précisées plus haut.

Parmi les composés organosiliciés sans oxygène, on peut citer les composés suivants :

| | |
|---|---|
| méthylsilane | CH₃-SiH₃ |
| diméthylsilane | (CH₃)₂-SiH₂ |
| triméthylsilane | (CH₃)₃-SiH |
| tétraméthylsilane | (CH₃)₄-Si |
| éthylsilane | CH₃-CH₂-SiH₃ |
| disilanométhane | SiH₃-CH₂-SiH₃ |
| bis(méthylsilano)méthane | CH₃-SiH₂-CH₂-SiH₂-CH₃ |
| 1,2-disilanoéthane | SiH₃-CH₂CH₂-SiH₃ |
| 1,2-bis(methylsilano)ethane | CH₃-SiH₂-CH₂-CH₂-SiH₂-CH₃ |
| 2,2-disilanopropane | SiH₃-C(CH₃)₂-SiH₃ |
| diéthylsilane | (C₂H₅)₂-SiH₂ |
| propylsilane | C₃H₇-SiH₃ |
| vinylméthylsilane | (CH₂=CH)-SiH₂-CH₃ |
| 1,1,2,2-tétraméthyldisilane | (CH₃)₃-SiH-SiH-(CH₃)₂ |
| hexamethyldisilane | (CH₃)₃-Si-Si-(CH₃)₃ |
| 1,1,2,2,3,3-hexamethyltrisilane | (CH₃)₂-SiH-Si(CH₃)₂-SiH-(CH₃)₂ |
| 1,1,2,3,3-pentaméthyltrisilane | (CH₃)₂-SiH-SiH(CH₃)-SiH-(CH₃)₂ |
| 1,3-bis(méthylsilano)propane | CH₃-SiH₂-(CH₂)₃-SiH₂-CH₃ |
| 1,2-bis(diméthylsilano)ethane | (CH₃)₂-SiH-(CH₂)₂-SiH-(CH₃)₂ |
| et | |
| 1,3-bis(diméthylsilano)propane | (CH₃)₂-Si-(CH₂)₃)-Si-(CH₃)₂ |
| bis(triméthylsilyméthane) | |

ainsi que le diphénylméthylsilane, le diméthylphénylsilane et le vinyltriméthylsilane.

Parmi les composés hydrocarbonés sans oxygène, on peut citer notamment le α-terpinène (ATP), le toluène et le méthane.

On peut aussi notamment utiliser un mélange d'un précurseur composé organosilicié sans oxygène, tel qu'un silane décrit plus haut, avec un précurseur composé hydrocarboné sans oxygène, par exemple le méthane CH₄.

Comme le matériau de la première couche ne contient pas d'oxygène, est exempt d'oxygène, on n'utilisera pas de gaz oxydant ; c'est par exemple le cas pour le dépôt d'une couche de SiC.

Eventuellement un ou plusieurs gaz vecteurs inertes sont introduits dans la chambre de dépôt en plus des précurseurs. Le ou les gaz inertes sont généralement choisis parmi l'hélium, l'azote,et leurs mélanges.

Dans le cas où on utilise différents précurseurs, un mélange de précurseurs, par exemple un précurseur composé hydrocarboné et un précurseur composé organosilicié, le rapport entre ces composés est généralement compris entre 10 : 1 et 1 : 10.

La première couche selon l'invention pourra ainsi être déposée à partir de triméthylsilane, de toluène et d'hélium ou bien à partir de triphénylméthylsilane et d'hélium.

Dans tous les cas, il est important que le dépôt par CVD, PECVD se fasse à basse température, de 20 à 250°C afin que la couche déposée ait une composition telle qu'elle comporte des groupes organiques tels que des groupes hydrocarbonés, et de préférence afin que cette couche soit riche en groupes organiques qui assurent la génération de gaz et le moussage lors de l'étape ultérieure de moussage.

Dans la deuxième étape du procédé de l'invention, on dépose sur la première couche mince de matériau diélectrique une seconde couche mince dite couche de « croûte » d'un matériau comprenant (de préférence consistant en) Si et au moins un autre atome choisi parmi H, O, C, N et F.

Il pourra s'agir de SiO₂ ou SiCNH.

Ce dépôt est effectué dans des conditions telles que cette seconde couche mince ait une composition qui ne permette pas qu'un gaz soit généré lors de l'étape de moussage ultérieure et telles que la densité de la seconde couche soit suffisante pour limiter voire empêcher la diffusion du gaz généré dans la première couche lors du traitement de moussage ultérieur.

En d'autres termes, les conditions de dépôt de cette seconde couche sont choisies pour éviter que cette couche mousse durant l'étape de traitement ultérieure destinée à produire la mousse.

En outre, le dépôt de la seconde couche doit généralement être effectué dans des conditions qui ne dégrade pas ou peu la première couche déposée par exemple de SiCH.

On réalisera donc ce dépôt généralement dans les conditions de basse température déjà spécifiées plus haut pour le dépôt de la première couche.

La composition de cette couche (qu'on peut donc appeler « croûte ») ainsi que son épaisseur seront généralement choisies de manière à être compatibles avec le traitement utilisé lors de l'étape de moussage ultérieure.

Cette couche doit être suffisamment dense pour rendre difficile voire impossible la diffusion du gaz généré dans la couche diélectrique lors de l'étape de moussage.

L'épaisseur de cette seconde couche sera donc, comme déjà précisé plus haut, et notamment de 5 à 1000 nm, de préférence de 10 à 100 nm, et sa densité sera généralement de 1,3 à 3.

La seconde couche ou « croûte » peut être déposée par un procédé analogue à celui utilisé pour le dépôt de la première couche mais de préférence, elle est déposée par un procédé de CVD, notamment de PECVD ou PACVD à partir d'un ou plusieurs précurseur(s), d'un ou plusieurs gaz oxydant(s) éventuel(s) et d'un ou plusieurs gaz inerte(s) éventuel(s).

Les précurseurs peuvent être choisis par exemple parmi les composés organosiliciés sans oxygène, les composés hydrocarbonés sans oxygène, l'ammoniac, et leurs mélanges. Mais pour le dépôt de cette seconde couche, ils pourront aussi être choisis parmi les composés avec oxygène et notamment parmi les composés organosiliciés avec oxygène, seuls ou en mélange avec un ou plusieurs précurseurs déjà cités.

Les précurseurs sans oxygène, gaz inertes utilisés dans un tel procédé ont déjà été décrits en détail plus haut.

Le ou les gaz oxydant(s) pourra(pourront) être choisi(s) parmi l'oxygène, l'eau, l'air, l'air enrichi en oxygène, le N₂O, et leurs mélanges.

Parmi les composés organosiliciés avec de l'oxygène, on peut citer les composés suivants :

| | |
|---|---|
| tétraéthyl-orthosilicate (TEOS) | |
| 1,3,5,7-tétraméthylcyclotetrasiloxane (TMCTS) | -(-SiHCH₃-O-)₄-(cyclique) |
| octméthylcyclotétrasiloxane (OMCTS) | -(-Si(CH₃)₂-O-)₄-(cyclique) |
| 1,3,5,7,9-pentaméthylcyclopentasiloxane | -(-SiHCH₃-O-O)₅- |
| (cyclique) | |
| 1,3,5,7-tétrasilano-2,6-dioxy-4,8-diméthyléne | -(-SiH₂-CH₂-SiH₂-O-)₂-(cyclique) |
| hexaméthylcyclotrisiloxane | -(-Si(CH₃)₂-O-)₃-(cyclique) |
| diéthoxyméthylsilane (DEMS) | CH₃-SiH-(O-CH₂-CH₃)₂ |
| 1,3-diméthyldisiloxane | CH₃-SiH₂-O-SiH₂-CH₃ |
| 1,1,3,3-tétraméthyldisiloxane | (CH₃)₂-SiH-O-SiH-(CH₃)₂ |
| hexaméthyldisiloxane (HMDS) | (CH₃)₃-Si-O-Si-(CH₃)₃ |
| 1,3-bis(silanométhylène)disiloxane | (SiH₃)-CH₂-SiH₂)₂ |
| bis(1-méthyldisiloxanyl)méthane | (CH₃-SiH₂-O-SiH₂-)₂-CH₂ |
| 2,2-bis(1-méthyldisiloxanyl)propane | (CH₃-SiH₂-O-SiH₂-)₂-C(CH₃)₂ |
| hexaméthoxydisilane (HMDOS), | (CH₃O)₃-Si-O-Si-(OCH₃)₃ |
| diméthyldiméthoxysilane (DMDMOS), et | (CH₃O)₂-Si-(CH₃)₂ |
| diméthoxyméthylvinylsilane (DMMVS) | (CH₃O)₂-Si-(CH₃)- |
| CH₂=CH₃. | |
| 1,3,5 triméthyl 1,3,5 trivinylcyclotrisiloxane | |
| diéthoxyméthyloxiranylsilane | |

Il est bien évident que l'on met en oeuvre un gaz oxydant et/ou un composé contenant de l'oxygène dans le cas où la seconde couche contient de l'oxygène par exemple lorsqu'il s'agit d'une couche de SiO₂. Si l'on souhaite préparer une couche de SICNH, on n'utilisera pas de gaz oxydant ni de précurseur contenant de l'oxygène.

Le dépôt par PECVD est de préférence réalisé dans des conditions de basse température déjà spécifiées plus haut.

Par exemple, on pourra utiliser du TEOS en présence d'oxygène, à faible température, par exemple 200°C, ou bien du triméthylsilane et de l'ammoniac en présence d'hélium.

De telles conditions entraînent peu ou pas de dégradation de la première couche, par exemple de SiCH.

La croûte peut également être réalisée par un traitement plasma de la surface de la première couche déposée, ce plasma comprenant de façon non exhaustive O₂, H₂, N₂, NH₃, N₂O, CO₂, CH₄, He, Ar, ... ou une combinaison de ces gaz. Toutefois, il est à noter que, dans ce cas, le contrôle de la profondeur et l'homogénéité de la croûte est plus difficile à réaliser.

Dans une troisième étape du procédé de l'invention, on traite l'ensemble, l'empilement, de la première couche et de la seconde couche dans des conditions telles qu'un gaz soit généré dans la première couche de préférence diélectrique, autrement dit, dans des conditions telles qu'elles permettent le moussage de la première couche. Ces conditions sont notamment des conditions telles qu'elles assurent la production d'un gaz à partir des groupes organiques présents dans la première couche.

Ce traitement est généralement un traitement thermique éventuellement combiné à un traitement par plasma, ou à un traitement par un rayonnement UV, ou à un traitement par un faisceau d'électrons. Le traitement thermique est généralement réalisé à une température de 250 à 500°C, par exemple à 400°C. Le plasma peut être par exemple un plasma H₂ ou N₂ etc...

La durée du traitement, qui est généralement de une à quelques minutes, par exemple de 1, ou 2 à 10 minuts, peut être ajusté pour faire varier le taux de porosité dans la couche.

Eventuellement dans une quatrième étape, la seconde couche ou couche « croûte » peut être retirée. En effet, en fonction de l'application visée, il sera parfois nécessaire de retirer la croûte de manière à avoir accès directement à la couche diélectrique poreuse. Le retrait de la croûte pourra être réalisé par exemple par un procédé de gravure plasma utilisant par exemple un gaz fluoré, un procédé de gravure chimique ou par polissage mécano-chimique (CMP). Dans tous les cas, le fait que la croûte ait une composition homogène en épaisseur et une épaisseur déterminée permet de mieux maîtriser le procédé de retrait de la croûte. Toutefois, il s'agit d'employer un procédé compatible avec le diélectrique poreux de manière à éviter sa dégradation.

L'invention concerne en outre une couche mince d'un matériau diélectrique nanoporeux à porosité homogène susceptible d'être obtenue par le procédé tel que décrit ci-dessous.

Les couches minces selon l'invention grâce à leur procédé de préparation ont intrinséquement un taux de nanoporosité élevé qui est généralement associé à une faible valeur de k telle que définie plus haut.

La porosité est homogène, répartie dans toute la couche, et la taille moyenne des pores est généralement de 0,5 à 4 nm.

L'invention a trait également à l'utilisation de ladite couche mince notamment comme diélectrique d'isolation dans des interconnexions métalliques et des membranes poreuses pour réalisation de cavités utilisées par exemple dans les interconnexions (« air gap »), à savoir des structures à pont d'air (« air-gap ») présentes dans les interconnexions.

L'invention va maintenant être décrite en référence aux exemples suivants donnés à titre illustratif et non limitatif.

### Exemple 1

On dépose une couche mince de 100 nm de SiCH par PECVD à basse température 60°C à partir de diphénylméthylsilane et d'hélium.

On dépose ensuite une couche d'oxyde de silicium d'une épaisseur de 50 nm sur la couche mince dans des conditions qui n'entraîne pas (ou peu) de dégradation du SiCH, à savoir un dépôt à 200°C, en utilisant du TEOS en présence d'oxygène.

L'empilement des deux couches est ensuite soumis à un traitement thermique à 400°C combiné à un plasma d'hydrogène qui permet le moussage de la couche de SiCH. La croûte de SiO₂ est ensuite retiré par gravure chimique dans un bain d'acide fluorhydrique (HF) peu concentré.

Ce type de couche (SiCH et même SiCNH) peut être utilisé ensuite comme membrane diélectrique perméable au HF pour la réalisation d'interconnexions de type air gap ou pour la réalisation de cavités pour les MEMS et les NEMS.

### Exemple 2

On dépose une couche mince de 100 nm de SiCH par PECVD à basse température (80°C) à partir de triméthylsilane, de toluène et d'hélium.

Le dépôt peut être réalisé dans un réacteur de type capacitif plan (par exemple sur un « producer » 300 mm de AMAT) avec les paramètres suivants : espace entre électrodes compris entre 300 et 500 mils, excitation de type radio fréquence à 13,56 MHz, puissance comprise entre 100 et 600W, température située entre 100 et 300°C, pression entre 4 et 10 Torrs.

Les débits de chaque précurseur sont compris entre 50 et 1000 cm3/minute et le rapport entre eux est compris entre 10:1 et 1:10.

On dépose ensuite une couche d'oxyde de silicium d'une épaisseur de 10 à 50 nm sur la couche mince dans des conditions qui n'entraîne pas (ou peu) de dégradation du SiCH à savoir un dépôt à 200°C, en utilisant du TEOS en présence d'oxygène.

L'empilement des deux couches est ensuite soumis à un traitement thermique à 400°C assisté par un rayonnement UV qui permet le moussage de la couche de SiCH.

Le temps de traitement (de une à quelques minutes, par exemple de 1, 2 à 10 minutes) peut être ajusté pour faire varier le taux de porosité dans la couche.

La croûte de SiO2 est ensuite éventuellement retirée par gravure plasma en utilisant un gaz fluoré.

### REFERENCES

**[1]** C. Xu et al., « Ultra low dielectric materials based on hybrid system of linear silicon precursor and organic porogen by plasma-enhanced chemical vapour deposition (PECVD)", US-A1-20040156987, May 27, 2004.
**[2]** K. Giles, "Low dielectric constant layers", US-B2-6 963 137, Nov. 8, 2005.
**[3]** L.L. Chapelon et al., « Characterization and integration of a CVD porous SiOCH (k<2.5) with enhanced mechanical properties for 65 nm CMOS interconnects and below", Microelec. Eng. 76 (2004)1.
**[4]** S. Merlet et al., « Preparation and characterization of nanocellular poly(phenylquinoxaline) foams. A new approach to nanoporous high performance polymers", "Macromolecules, 40 (2007) 2070.
**[5]** H. Yokoyama et al., « Nanocellular structures in block copolymers with CO2-philic blocks using CO2 as a blowing agent : crossover from micro- to nanocellular structures with depressurization temperature", Macromolecules, 38 (2005) 10516.
**[6]** WO-A-03/044843
**[7]** US-A1-2003/124870
**[8]** WO-A-2006/079979

## Revendications

1. Procédé de préparation d'une couche mince d'un matériau diélectrique nanoporeux à porosité homogène dans lequel on réalise les étapes successives suivantes :
- on dépose une première couche mince d'un premier matériau choisi parmi SiCH, SiCN, SiCNH, SiCF et les matériaux biphasiques avec une phase contenant Si, C, H et une phase organique porogène contenant C, H sur un substrat, le dépôt de ladite première couche étant effectué à une température de 20°C à 250°C ;
- on dépose sur la première couche une seconde couche mince, dite croûte, d'un second matériau choisi parmi SiO₂ et SiCNH, ladite seconde couche ayant une épaisseur de 5 à. 1500 nm, de préférence de 10 à 1000 nm, de préférence encore de 80 à 600 nm, et une densité de 1,3 à 3 ;
- on traite l'ensemble de la première couche et de la seconde couche dans des conditions telles qu'un gaz soit généré dans la première couche pour permettre son moussage et la création de nanopores dans celle-ci, ledit traitement étant un traitement thermique combiné éventuellement à un traitement au plasma, ou à un traitement par un rayonnement UV ou à un traitement par un faisceau d' électrons ;
- on retire éventuellement la seconde couche mince.

2. Procédé selon la revendication 1, dans lequel la première couche mince a une épaisseur de 5 à 1500 nm, de préférence de 10 à 1000 nm de préférence encore de 80 à 600 nm.

3. Procédé selon l'une quelconque des revendications précédentes, dans lequel les nanopores ont une dimension définie par leur diamètre moyen, inférieure à 10 nm, de préférence de 0,5 à 4 nm.

4. Procédé selon l'une quelconque des revendications précédentes, dans lequel le dépôt de la première couche est effectué par un procédé choisi parmi le dépôt chimique en phase vapeur CVD, le procédé de dépôt chimique en phase vapeur assisté par plasma PECVD ou PACVD, et le procédé d'enduction centrifuge.

5. Procédé selon la revendication 4, dans lequel le dépôt de la première couche est effectué par un procédé de dépôt chimique en phase vapeur CVD, ou un procédé de dépôt chimique en phase vapeur assisté par plasma PECVD ou PACVD qui utilise un ou des précurseur(s) choisi(s) parmi les composés organosiliciés sans oxygène, les composés hydrocarbonés sans oxygène, l'ammoniac, et leurs mélanges.

6. Procédé selon la revendication 5, dans lequel le dépôt de la première couche est effectué en présence d'un ou plusieurs gaz inerte(s).

7. Procédé selon l'une quelconque des revendications précédentes, dans lequel la première couche est déposée à partir de triméthylsilane, de toluène, d'hélium, ou bien à partir de triphénylméthylsilane et d'hélium.

8. Procédé selon l'une quelconque des revendications précédentes, dans lequel la seconde couche est déposée par un procédé de dépôt chimique en phase vapeur, ou un procédé de dépôt chimique en phase vapeur assisté par plasma à partir d'un ou plusieurs précurseur(s), éventuellement d'un ou plusieurs gaz oxydant(s) et éventuellement d'un ou plusieurs gaz inerte(s).

9. Procédé selon l'une quelconque des revendications 1 à 7, dans lequel la seconde couche est réalisée par un traitement plasma de la surface de la première couche déposée.

10. Procédé selon l'une quelconque des revendications précédentes, dans lequel le traitement thermique de l'ensemble de la première couche et de la seconde couche est réalisé à une température de 250°C à 500°C.

11. Procédé selon l'une quelconque des revendications précédentes, dans lequel la seconde couche mince est retirée par un procédé choisi parmi un procédé de gravure plasma, un procédé de gravure chimique ou un procédé de polissage mécano-chimique CMP.

12. Couche mince d'un matériau diélectrique-nanoporeux à porosité homogène susceptible d'être obtenue par le procédé selon l'une quelconque des revendications 1 à 11.

13. Utilisation de la couche mince selon la revendication 12 comme diélectrique d'isolation dans des interconnexions métalliques.

14. Utilisation de la couche mince selon la revendication 12 pour réaliser des structures à pont-d'air présents dans les interconnexions.

## Claims

1. Process for preparing a thin layer of a nanoporous dielectric material with homogeneous porosity in which the following successive steps are performed:
- a first thin layer of a first material chosen from SiCH, SiCN, SiCNH, SiCF and the biphasic materials with a phase containing Si, C, H and a porogenic organic phase containing C, H, is deposited on a substrate, the deposition of said first layer being performed at a temperature of 20 to 250°C;
- on the first layer, a second thin layer so-called crust of a second material chosen from SiO₂ and SiCNH is deposited, said second layer having a thickness of 5 to 1500 nm, preferably of 10 to 1000 nm, more preferably of 80 to 600 nm and a specific gravity of 1.3 to 3;
- the first layer and second layer assembly is treated under conditions so that a gas is generated in the first layer in order to enable the foaming thereof and the creation of nanopores therein, said treatment being a heat treatment optionally combined with a plasma treatment, or with a UV radiation treatment or with an electron beam treatment;
- the second thin layer is optionally removed.

2. Process according to claim 1, wherein the first thin layer has a thickness of 5 to 1500 nm, preferably 10 to 1000 nm, and more preferably 80 to 600 nm.

3. Process according to any one of the preceding claims, wherein the nanopores have a dimension defined by their average diameter, smaller than 10 nm, preferably from 0.5 to 4 nm.

4. Process according to any one of the preceding claims, wherein the deposition of the first layer is performed by a process chosen from the chemical vapor deposition process CVD, the plasma-assisted or plasma-enhanced chemical vapor deposition processes PECVD or PACVD, and the spin coating process.

5. Process according to claim 4, wherein the deposition of the first layer is performed by a chemical vapor deposition process CVD, or a plasma-assisted or plasma-enhanced chemical vapor deposition process PECVD or PACVD, which uses one or more precursor(s) chosen from oxygen-free organosilicon compounds, oxygen-free hydrocarbon compounds, ammonia, and mixtures thereof.

6. Process according to claim 5, wherein the deposition of the first layer is performed in the presence of one or more inert gas(es).

7. Process according to any one of the preceding claims, wherein the first layer is deposited from trimethylsilane, toluene and helium, or from triphenylmethylsilane and helium.

8. Process according to any one of the preceding claims, wherein the second layer is deposited by a chemical vapor deposition process, or a plasma-assisted chemical vapor deposition process from one or more precursor(s), optionally one or more oxidizing gas(es) and optionally one or more inert gas(es).

9. Process according to any one of claims 1 to 7, wherein the second layer is produced by a plasma treatment on the surface of the first deposited layer.

10. Process according to any one of the preceding claims, wherein the heat treatment of the first layer and second layer assembly is performed at a temperature of 250 to 500 °C.

11. Process according to any one of the preceding claims, wherein the second thin layer is removed by a process chosen from a plasma etching process, a chemical etching process or a chemical mechanical polishing CMP process.

12. Thin layer of a nanoporous dielectric material, having a homogeneous porosity, obtainable by the process according to any one of claims 1 to 11.

13. Use of the thin layer according to claim 12, as an insulation dielectric in metal interconnections.

14. Use of the thin layer according to claim 12, to produce air gap structures present in interconnections.

## Patentansprüche

1. Herstellungsverfahren einer Dünnschicht aus einem nanoporösen dielektrischen Material mit homogener Porosität, bei dem man die aufeinanderfolgenden Schritte ausführt:
- man scheidet eine erste Dünnschicht aus einem ersten Material auf einen substrat ab, ausgewählt unter SiCH, SiCN, SiCNH, SiCF und den biphasischen Materialien mit einer Si, C, H enthaltenden Phase und einer C, H enthaltenden organischen porenbildenden Phase, wobei die Abscheidung der genannten ersten Schicht bei einer Temperatur von 20 °C bis 250 °C durchgeführt wird;
- man scheidet auf der ersten Schicht eine zweite Dünnschicht, Krustenschicht genannt, aus einem zweiten Material ab, ausgewählt zwischen SiO₂ und SiCNH, wobei die genannte zweite Schicht eine Dicke von 5 bis 1500 nm, bevorzugt 10 bis 1000 nm, noch bevorzugter 80 bis 600 nm, und eine Dichte von 1,3 bis 3 hat;
- man unterzieht das aus der ersten Schicht und der zweiten Schicht bestehende Gesamtheit einer Behandlung unter solchen Bedingungen, dass in der ersten Schicht ein Gas erzeugt wird, um ihre Schäumung und die Erzeugung von Nanoporen in ihr zu realisieren, wobei die genannte Behandlung eine Wärmebehandlung ist, eventuell kombiniert mit einer Plasmabehandlung oder einer UV-Bestrahlungsbehandlung oder einer Elektronenstrahlbehandlung;
- man entfernt eventuell die zweite Dünnschicht.

2. Verfahren nach Anspruch 1, bei dem die erste Dünnschicht eine Dicke von 5 bis 1500 nm, bevorzugt 10 bis 1000 nm, noch bevorzugter 80 bis 600 nm hat.

3. Verfahren nach einem der vorhergehenden Ansprüche, bei dem die Nanoporen einen durch ihren mittleren Durchmesser definierten Dimension von weniger als 10 nm und vorzugsweise 0,5 bis 4 nm haben.

4. Verfahren nach einem der vorhergehenden Ansprüche, bei dem die Abscheidung der ersten Schicht durch ein Verfahren realisiert wird, das ausgewählt wird unter CVD, PECVD oder PACVD und Rotationsbeschichtung (spin coating).

5. Verfahren nach Anspruch 4, bei dem die Abscheidung der ersten Schicht realisiert wird durch ein Verfahren des Typs CVD oder PECVD oder PACVD, das einen Ausgangsstoff oder Ausgangsstoffe benutzt, ausgewählt unter den organischen Siliciumverbindungen ohne Sauerstoff, den Kohlenwasserstoffverbindungen ohne Sauerstoff, dem Ammoniak, und ihren Gemischen.

6. Verfahren nach Anspruch 5, bei dem die Abscheidung der ersten Schicht unter Präsenz von einem oder mehreren inerten Gas(en) erfolgt.

7. Verfahren nach einem der vorhergehenden Ansprüche, wobei die Abscheidung der ersten Schicht auf Trimethylsilan, Toluol und Helium, oder auf Triphenylmethylsilan und Helium basiert.

8. Verfahren nach einem der vorhergehenden Ansprüche, wobei die zweite Schicht abgeschieden wird durch ein CVD-Verfahren oder ein PACVD-Verfahren, basierend auf einem Ausgangsstoff oder Ausgangsstoffen, eventuell einem oder mehreren oxidierenden Gas(en) und eventuell einem oder mehreren inerten Gas(en).

9. Verfahren nach einem der Ansprüche 1 bis 7, bei dem die zweite Schicht realisiert wird durch eine Plasmabehandlung der Oberfläche der ersten abgeschiedenen Schicht.

10. Verfahren nach einem der vorhergehenden Ansprüche, bei dem die thermische Behandlung der Gesamtheit aus erster Schicht und zweiter Schicht bei einer Temperatur von 250 °C bis 500 °C erfolgt.

11. Verfahren nach einem der vorhergehenden Ansprüche, bei dem die zweite Dünnschicht durch ein Verfahren entfernt wird, das ausgewählt wird unter einem Plasmaätzverfahren, einem chemischen Ätzverfahren oder einem mechanisch-chemischen Polierverfahren (CMP).

12. Dünnschicht aus einem nanoporösen dielektrischen Material mit homogener Porosität, hergestellt durch das Verfahren nach einem der Ansprüche 1 bis 11.

13. Verwendung der Dünnschicht nach Anspruch 12 als dielektrische Isolation bei metallischen Verbindungen bzw. Verbindungsleitungen.

14. Verwendung der Dünnschicht nach Anspruch 12, um bei den Verbindungen bzw.
Verbindungsleitungen vorhandene Luftspalt-Strukturen zu realisieren.
